# EUROPEAN PATENT SPECIFICATION

(11) **EP 3 493 266 B1**
(45) Date of publication and mention of the grant of the patent: **20.11.2024**
(21) Application number: 17844852.8
(22) Date of filing: 20.03.2017
(51) Int. Cl.: H01L 29/06, H01L 21/02, H01L 29/78

(54) **SEMICONDUCTOR WAFER HAVING THREE-DIMENSIONAL STRUCTURE**
HALBLEITERWAFER MIT DREIDIMENSIONALER STRUKTUR
PLAQUETTE SEMI-CONDUCTRICE AYANT UNE STRUCTURE TRIDIMENSIONNELLE

(30) Priority: 29.08.2016 CN 201610736822
(43) Date of publication of application: 05.06.2019
(73) Proprietor: Luoyang Hongtai Semiconductor Co., Ltd, Luoyang, Henan 471003 (CN)
(72) Inventor: WANG, Jun, Henan Province (CN); DENG, Jianwei, Henan Province (CN); SHEN, Zheng, Henan Province (CN)
(74) Representative: Bandpay & Greuter
(86) International application number: PCT/CN2017/077226
(87) International publication number: WO 2018/040544

(56) References cited:
- WO-A1-03/028076
- CN-A- 102 214 678
- CN-A- 103 035 643
- CN-A- 106 129 108
- CN-U- 205 920 958
- CN-U- 205 920 971
- CN-U- 205 920 972
- CN-U- 205 944 097
- CN-U- 205 992 533
- JP-A- 2001 127 289
- US-A1- 2007 111 386
- US-A1- 2008 164 575
- US-A1- 2012 068 310
- US-B1- 6 465 863

## Description

### BACKGROUND OF THE PRESENT INVENTION

### Field of Invention

The present invention relates to a three-dimensional semiconductor wafer.

### Description of Related Arts

Generally, the wafer material applied in the production of the semiconductor chip is mainly single crystal epitaxial wafer and single crystal polished wafer. The epitaxial wafer is obtained through forming an epitaxial layer on the single crystal polished wafer serving as the substrate layer, wherein the substrate layer is for supporting and the epitaxial layer is applied in producing the semiconductor chip. The high-voltage semiconductor chip requires a higher epitaxial layer thickness. With the increase of the epitaxial layer thickness, not only the cost greatly increases, but also the defect density increases, so that it is failed to meet the production requirements of the high-voltage large-power semiconductor chip, and the substrate layer limits the performance of the semiconductor chip.

The semiconductor material which is represented by silicon is hard and crisp. The single crystal epitaxial wafer and the single crystal polished wafer require certain thickness, so as to increase the strength thereof. During the production process of the semiconductor chip, backgrinding is necessary for removing the excess thickness, causing the high cost and the high technical difficulty.

With higher and higher requirements on energy saving and cost reducing, the requirements on the voltage and power consumption of the semiconductor device becomes high and higher. The requirement on the working voltage of the semiconductor device gradually increases to 6500 V and even higher, while the voltage of the semiconductor device, which is produced based on the epitaxial wafer, is generally not higher than 1700 V. The limitation of the epitaxial wafer is obvious, and because of being limited by the inherent characteristics of the conventional semiconductor wafer material, the power consumption bottleneck of the semiconductor device is not effectively and greatly reduced. Moreover, the power semiconductor production gradually enters the high-integration-level submicron complementary metal-oxide-semiconductor (CMOS) age. However, based on the conventional semiconductor wafer material, the submicron CMOS production process is radically not compatible with the three-dimensional deep-PN-junction structure required by the high-voltage large-power device, which becomes the key bottleneck of the continuous development of the high-performance power semiconductor.

Document JP2001-127289 A discloses a substrate having n-type impurities provided with trenches in which p-type pillars are formed by means of epitaxy thus forming a superjunction structure. According to an example, said substrate can also be bonded to a SOI substrate. A back side of the SOI substrate is removed together with a buried insulating layer thus forming a thin, n-type device layer on top of the superjunction layer.

Document WO 03028076 A1 discloses a method of manufacturing semiconductor device. The method includes etching grooves in a first and a second semiconductor substrates having n-type and p-type conductivity types respectively. The areas of grooves in the first semiconductor substrate correspond to the areas without grooves in the second semiconductor substrate.

Two semiconductor substrates are directly bonded together so that the grooves in the first semiconductor substrate are filled with the grooves in the second semiconductor substrate thus forming a superjunction structure.

### SUMMARY OF THE PRESENT INVENTION

An object of the present invention is to provide a three-dimensional semiconductor wafer as defined in claim 1, so as to solve problems in prior arts. According to the present invention, at least one connection layer and a conduction layer are arranged on a semiconductor wafer unit, so as to improve semiconductor performance. The preferred embodiment is defined in claim 2.

In order to accomplish the above object, the present invention adopts following technical solutions.

A three-dimensional semiconductor wafer is defined in claim 1 and comprises a semiconductor wafer unit, at least one connection layer, a conduction layer and a protection layer, wherein: the protection layer is arranged on the conduction layer; and, the connection layer and the conduction layer are arranged on the semiconductor wafer unit at a bottom surface of the semiconductor wafer unit.

Preferably, the semiconductor wafer unit is cylindrical.

Through adopting the above technical solutions, the present invention and not claimed examples useful for understanding the present invention have following beneficial effects.

Through arranging the connection layer and the conduction layer on the semiconductor wafer unit, a semiconductor performance is increased. The three-dimensional semiconductor wafer provided by the present invention not only replaces two-dimensional semiconductor wafer materials such as a single crystal epitaxial wafer, but also provides a design basis for a semiconductor device.

According to a not claimed example being useful for understanding the invention, firstly, a three-dimensional deep-junction structure namely the connection layer, for withstanding a high voltage, is formed on the semiconductor wafer unit, which solves a process contradiction between a submicron complementary metal-oxide-semiconductor (CMOS) process and a deep-PN-junction structure of a power semiconductor chip, simplifies a production process of the power semiconductor chip, and reduces a production difficulty of the power semiconductor chip.

Secondly, the present invention effectively increases a current density of the semiconductor chip. Compared with a conventional semiconductor chip, a power loss of the semiconductor chip based on the present invention is decreased by more than 30%.

Thirdly, the present invention reduces a defect density of a high resistance area of the semiconductor wafer and greatly decreases a leak current of the semiconductor chip. Compared with the conventional semiconductor chip, the leak current of the semiconductor chip based on the present invention can be decreased by 1-2 magnitudes.

Fourthly, the present invention increases a secondary breakdown tolerance of the power semiconductor. Compared with the conventional semiconductor chip, the secondary breakdown tolerance of the semiconductor chip based on the present invention is increased by more than 50%, so that an anti-burn ability of the device is radically improved.

Fifthly, because of an effect of the connection layer, an ultrathin requirement on the semiconductor wafer is greatly reduced, which solves a processing technology difficulty of an ultrathin sheet when backside metalizing based on the conventional semiconductor wafer.

Sixthly, the three-dimensional structure of the present invention is able to greatly decrease a thermal stress of the semiconductor wafer, so that the semiconductor wafer is more flat and has more toughness, and is difficult to be broken during the production process of the semiconductor chip.

Seventhly, each parameter of the three-dimensional semiconductor wafer has a good controllability. An electrical resistivity is selectable in a range of 0.5-2000 Ω·cm, a difference of the electrical resistivity is controlled in ±5%, and an in-plane electrical resistivity nonuniformity is controlled in 6%; a total thickness is selectable in a range of 150-2000 µm; a thickness of the high resistance area of the semiconductor wafer is customizable in a range of 10-1000 µm, and a thickness difference of the high resistance area of the semiconductor wafer is controlled in ±2.5 µm.

Eighthly, the semiconductor device produced based on the present invention is able to realize a working voltage of 6500 V, 7200 V, 8500 V and even higher, namely the present invention is applicable in producing various semiconductor devices with a working voltage from several volts to over ten thousand volts.

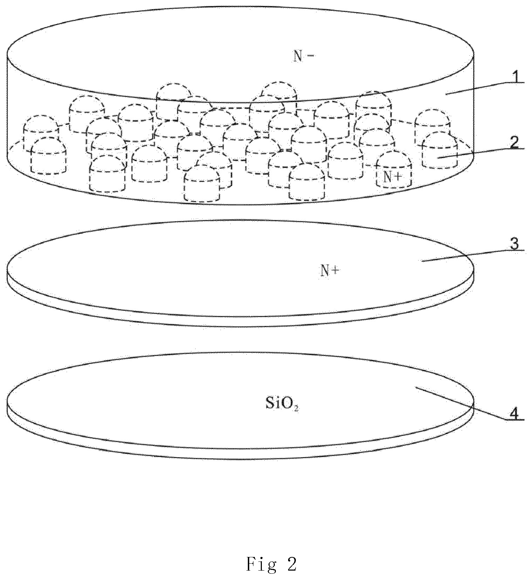

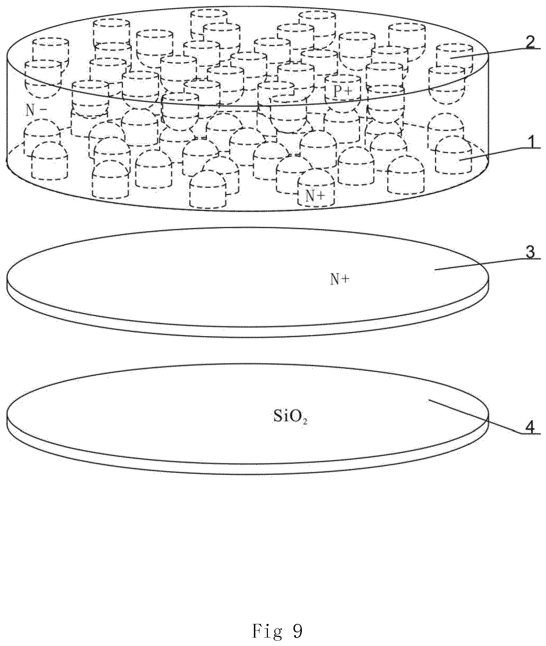

The present invention has a high practicability, an easy operation, a rigorous, coordinated and effective control plan, a smart design and an easy implementation, which greatly improves the semiconductor performance and meanwhile brings the convenience to the use of the customer. In the following parts of the description the terms and expressions "embodiment" and "preferred embodiment of the present invention" are used. Irrespective of these terms and expressions, only the preferred embodiments as shown in Figures 2 and 9 fall under the scope of the independent claim 1 and therefore they form part of the invention.

Embodiments shown in figures 1 and 3 - 8 correspond to not claimed examples useful for understanding the present invention.

### BRIEF DESCRIPTION OF THE DRAWINGS

Fig. 1 is an exploded view of a three-dimensional semiconductor wafer according to embodiments.
Fig. 2 is an exploded view of an (N⁻/N⁺/N⁺)-typed three-dimensional semiconductor wafer according to a first preferred embodiment of the present invention.
Fig. 3 is an exploded view of an (N⁻/P⁺/P⁺)-typed three-dimensional semiconductor wafer according to a second preferred embodiment not forming the present invention but useful for its understanding.
Fig. 4 is an exploded view of an (N⁻/N⁺/P⁺)-typed three-dimensional semiconductor wafer according to a third preferred embodiment not forming the present invention but useful for its understanding.
Fig. 5 is an exploded view of an (N⁻/P⁺/N⁺)-typed three-dimensional semiconductor wafer according to a fourth preferred embodiment not forming the present invention but useful for its understanding.
Fig. 6 is an exploded view of a (P⁻/P⁺/P⁺)-typed three-dimensional semiconductor wafer according to a fifth preferred embodiment not forming the present invention but useful for its understanding.
Fig. 7 is an exploded view of a (P⁻/N⁺/N⁺)-typed three-dimensional semiconductor wafer according to a sixth preferred embodiment not forming the present invention but useful for its understanding.
Fig. 8 is an exploded view of an (N⁻/P⁺ top surface/N⁺)-typed three-dimensional semiconductor wafer according to a seventh preferred embodiment not forming the present invention but useful for its understanding.
Fig. 9 is an exploded view of an (N⁻/P⁺ top surface/N⁺ bottom surface/N⁺)-typed three-dimensional semiconductor wafer according to an eighth preferred embodiment.

In the drawings: 1: semiconductor wafer unit; 2 connection part; 3: conduction layer; and 4: protection layer.

### DETAILED DESCRIPTION OF THE PREFERRED EMBODIMENT

The present invention is illustrated in detail with the following preferred embodiments. An object of disclosing the present invention is to protect all modifications encompassed within the scope of the present invention as defined by the appended claims.

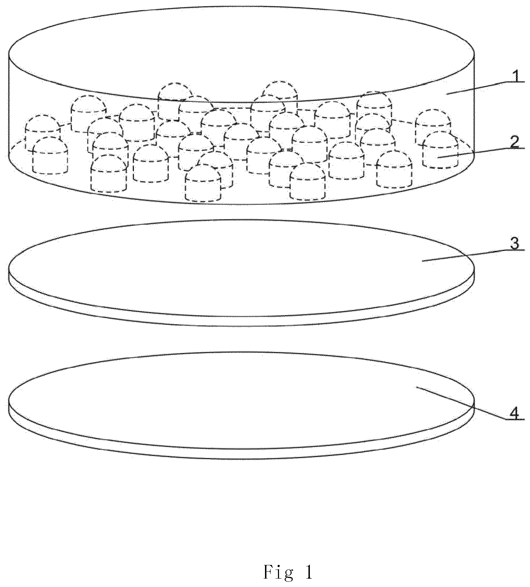

Referring to Fig. 1, a three-dimensional semiconductor wafer comprises a semiconductor wafer unit 1, at least one connection layer, a conduction layer 3 and a protection layer 4, wherein: the protection layer 4 is arranged on the conduction layer 3; the connection layer and the conduction layer 3 are arranged on the semiconductor wafer unit 1 at any surface of the semiconductor wafer unit 1; the semiconductor wafer unit 1 is cylindrical; the connection layer is arranged on a bottom surface of the semiconductor wafer unit 1; the connection layer comprises a plurality of connection parts 2; a first end of each connection part 2 is inserted into the semiconductor wafer unit 1, and a second end of each connection part 2 is level with the bottom surface of the semiconductor wafer unit 1; the connection parts 2 are prismatic, cylindrical, circular or elliptic; the connection parts 2 are arranged inside the semiconductor wafer unit 1 in a form of array; the conduction layer 3 is arranged on the bottom surface of the semiconductor wafer unit 1; and the protection layer 4 is arranged on an outer surface of the conduction layer 3.

For the three-dimensional semiconductor wafer, according to types of semiconductors of different power, a conduction type of the three-dimensional semiconductor wafer unit 1, the connection layer, and the conduction layer 3 can be respectively selected as N-type or P-type, wherein the bottom surface of the semiconductor wafer unit 1 can be produced according to requirements of a chip.

First preferred embodiment: (N⁻/N⁺/N⁺)-typed three-dimensional semiconductor wafer.

Referring to Fig. 2, the semiconductor wafer unit 1 is a high resistance area with the conduction type of N-type, namely an N⁻ area; the connection layer is a high concentration area with the conduction type of N-type, namely an N⁺ area; for the array-distributed connection parts 2, the first ends are inserted into the semiconductor wafer unit 1, and the second ends are connected to each other on the bottom surface of the semiconductor wafer unit 1 through the conduction layer 3; the conduction layer 3 is a high concentration area with the conduction type of N-type, namely the N⁺ area; and the protection layer 4 is arranged on the conduction layer 3 at the bottom surface of the semiconductor wafer unit 1. The above three-dimensional semiconductor wafer is mainly applicable in production of metal-oxide-semiconductor field-effect transistor (MOSFET) and fast recovery diode (FRD). Through a design and an implementation of the unique three-dimensional connection parts, a MOSFET chip has an increased current density and a power loss decreased by more than 30%, so that a layout area of the chip is effectively decreased and a composite cost of the chip is reduced. Moreover, a softness factor of a FRD chip is increased.

Second preferred embodiment: (N⁻/P⁺/P⁺)-typed three-dimensional semiconductor wafer, not forming part of the present invention but useful for its understanding.

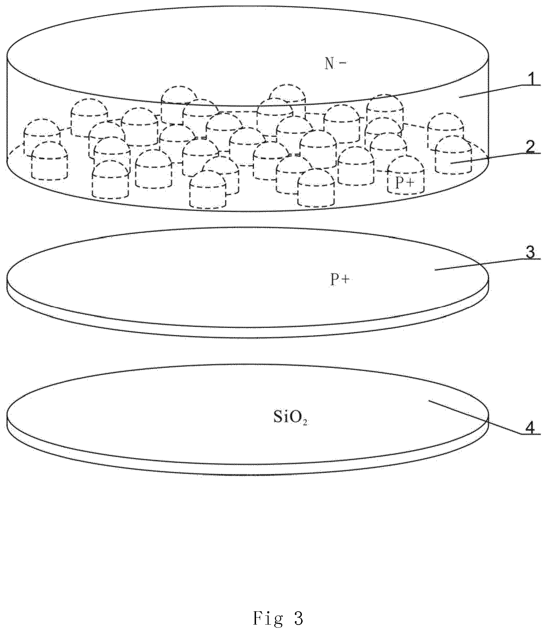

Referring to Fig. 3, the semiconductor wafer unit 1 is a high resistance area with the conduction type of N-type, namely an N⁻ area; the connection layer is a high concentration area with the conduction type of P-type, namely a P⁺ area; for the array-distributed connection parts 2, the first ends are inserted into the semiconductor wafer unit 1, and the second ends are connected to each other on the bottom surface of the semiconductor wafer unit 1 through the conduction layer 3; the conduction layer 3 is a high concentration area with the conduction type of P-type, namely the P⁺ area; and the protection layer 4 is arranged on the conduction layer 3 at the bottom surface of the semiconductor wafer unit 1. The above three-dimensional semiconductor wafer is mainly applicable in production of insulated gate bipolar transistor (IGBT). Through adopting the three-dimensional semiconductor wafer to produce an IGBT chip, complex technological processes such as wafer backgrinding and P⁺ injection, before backside metallization, in a conventional IGBT chip production process is reduced, and a production process of the IGBT chip is completely same as a production process of a vertical double-diffused metal-oxide-semiconductor (VDMOS), so that the production of the IGBT chip is simplified, optimized and easily realized. That is to say, a production line having a production capacity of the VDMOS chip is able to produce the IGBT chip, so that a capital investment of a dedicated IGBT production line is reduced and a finished product rate of the chip is increased, which is more beneficial to development and widespread application of the IGBT.

Third preferred embodiment: (N⁻/N⁺/P⁺)-typed three-dimensional semiconductor wafer, not forming part of the present invention but useful for its understanding.

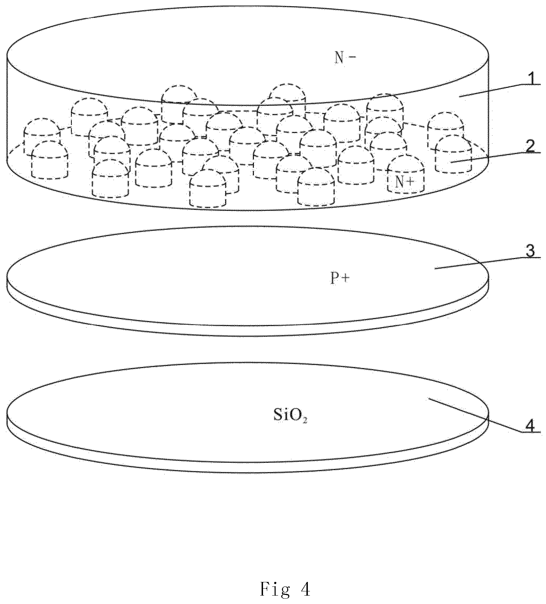

Referring to Fig. 4, the semiconductor wafer unit 1 is a high resistance area with the conduction type of N-type, namely an N⁻ area; the connection layer is a high concentration area with the conduction type of N-type, namely an N⁺ area; for the array-distributed connection parts 2, the first ends are inserted into the semiconductor wafer unit 1, and the second ends are connected to each other on the bottom surface of the semiconductor wafer unit 1 through the conduction layer 3; the conduction layer 3 is a high concentration area with the conduction type of P-type, namely a P⁺ area; and the protection layer 4 is arranged on the conduction layer 3 at the bottom surface of the semiconductor wafer unit 1. The above three-dimensional semiconductor wafer is mainly applicable in production of IGBT with anodes in parallel. The IGBT with the anodes in parallel, which is produced through adopting the three-dimensional semiconductor wafer, has an excellent high-speed switch function with a switch frequency of 50 KHz, a lower power loss and a higher efficiency.

Fourth preferred embodiment: (N⁻/P⁺/N⁺)-typed three-dimensional semiconductor wafer, not forming part of the present invention but useful for its understanding.

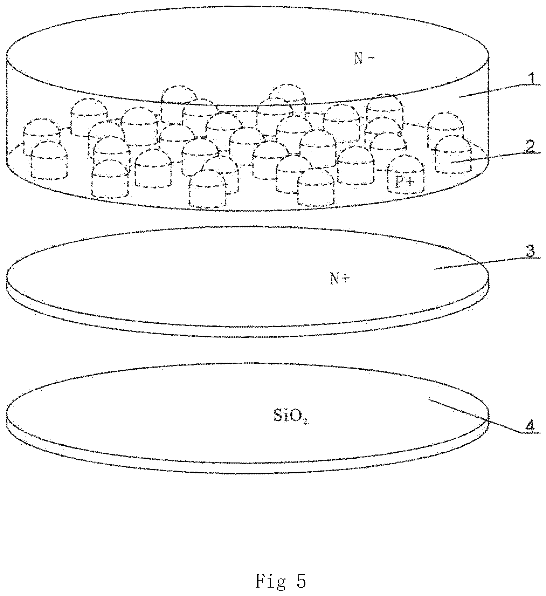

Referring to Fig. 5, the semiconductor wafer unit 1 is a high resistance area with the conduction type of N-type, namely an N⁻ area; the connection layer is a high concentration area with the conduction type of P-type, namely a P⁺ area; for the array-distributed connection parts 2, the first ends are inserted into the semiconductor wafer unit 1, and the second ends are connected to each other on the bottom surface of the semiconductor wafer unit 1 through the conduction layer 3; the conduction layer 3 is a high concentration area with the conduction type of N-type, namely an N⁺ area; and the protection layer 4 is arranged on the conduction layer 3 at the bottom surface of the semiconductor wafer unit 1. The above three-dimensional semiconductor wafer is mainly applicable in production of N-channel enhancement mode MOSFET and FRD chip. An N-channel enhancement mode MOSFET chip, which is produced through adopting the three-dimensional semiconductor wafer, has a power loss decreased by more than 30% and a secondary breakdown tolerance increased by more than 50%.

Fifth preferred embodiment: (P⁻/P⁺/P⁺)-typed three-dimensional semiconductor wafer, not forming part of the present invention but useful for its understanding.

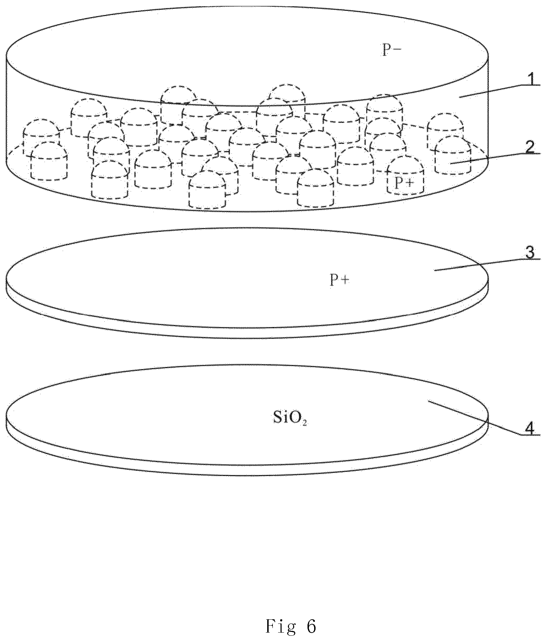

Referring to Fig. 6, the semiconductor wafer unit 1 is a high resistance area with the conduction type of P-type, namely a P⁻ area; the connection layer is a high concentration area with the conduction type of P-type, namely a P⁺ area; for the array-distributed connection parts 2, the first ends are inserted into the semiconductor wafer unit 1, and the second ends are connected to each other on the bottom surface of the semiconductor wafer unit 1 through the conduction layer 3; the conduction layer 3 is a high concentration area with the conduction type of P-type, namely the P⁺ area; and the protection layer 4 is arranged on the conduction layer 3 at the bottom surface of the semiconductor wafer unit 1. The above three-dimensional semiconductor wafer is mainly applicable in production of P-channel enhancement mode MOSFET and giant transistor (GTR).

Sixth preferred embodiment: (P⁻/N⁺/N⁺)-typed three-dimensional semiconductor wafer, not forming part of the present invention but useful for its understanding.

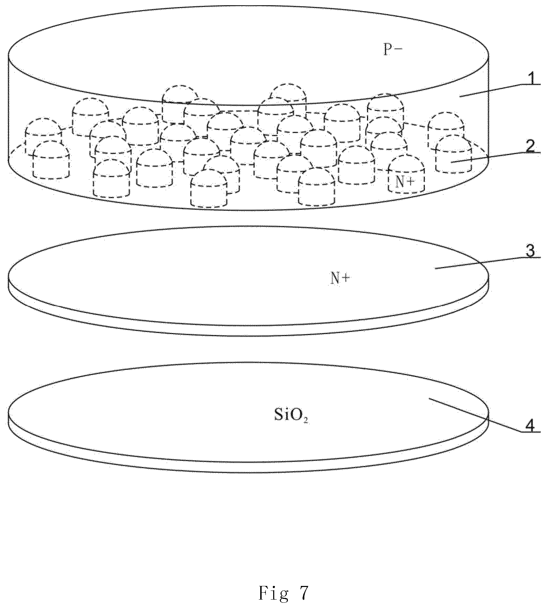

Referring to Fig. 7, the semiconductor wafer unit 1 is a high resistance area with the conduction type of P-type, namely a P⁻ area; the connection layer is a high concentration area with the conduction type of N-type, namely an N⁺ area; for the array-distributed connection parts 2, the first ends are inserted into the semiconductor wafer unit 1, and the second ends are connected to each other on the bottom surface of the semiconductor wafer unit 1 through the conduction layer 3; the conduction layer 3 is a high concentration area with the conduction type of N-type, namely the N⁺ area; and the protection layer 4 is arranged on the conduction layer 3 at the bottom surface of the semiconductor wafer unit 1. The above three-dimensional semiconductor wafer is mainly applicable in production of Cool metal-oxide-semiconductor (MOS). Compared with conventional Power MOS, an on-resistance of the Cool MOS is decreased by 3-5 times. However, the production of the Cool MOS is complex that more than 10 times of ion injection and epitaxy are required, a technical difficulty is high and a cost is high. Through adopting the three-dimensional semiconductor wafer to produce a Cool MOS chip, an array-distributed three-dimensional structure withstanding a high voltage is directly formed, which simplifies the complex production process of the Cool MOS chip and reduces a production difficulty thereof, so that a technical breakthrough of Cool MOS production is realized.

Seventh preferred embodiment: (N⁻/P⁺ top surface/N⁺)-typed three-dimensional semiconductor wafer, not forming part of the present invention but useful for its understanding.

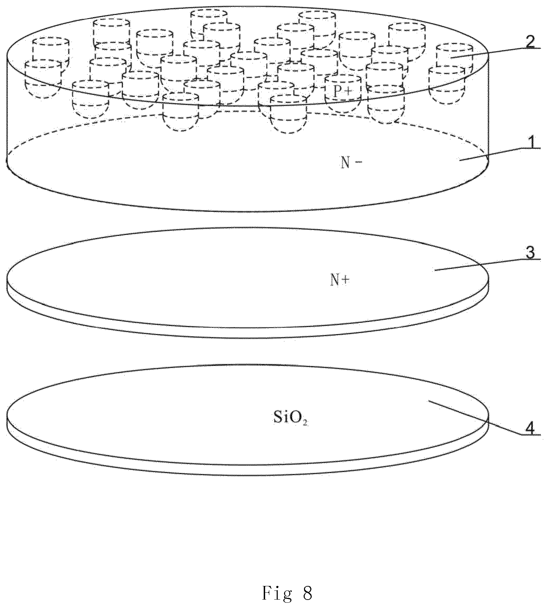

Referring to Fig. 8, the semiconductor wafer unit 1 is a high resistance area with the conduction type of N-type, namely an N⁻ area; the connection layer is a high concentration area with the conduction type of P-type, namely a P⁺ area; for the array-distributed connection parts 2, the first ends are inserted into the semiconductor wafer unit 1, and the second ends are level with a top surface of the semiconductor wafer unit 1; the conduction layer 3 is a high concentration area with the conduction type of N-type, namely an N⁺ area; and the protection layer 4 is arranged on the conduction layer 3 at the bottom surface of the semiconductor wafer unit 1. The above three-dimensional semiconductor wafer is mainly applicable in production of Cool MOS. Through adopting the customized three-dimensional semiconductor wafer to produce a Cool MOS chip, a production difficulty is reduced, a chip cost is greatly decreased, and a better cost performance at an application client is achieved.

Eighth preferred embodiment: (N⁻/P⁺ top surface/N⁺ bottom surface/N⁺)-typed three-dimensional semiconductor wafer.

Referring to Fig. 9, the semiconductor wafer unit 1 is a high resistance area with the conduction type of N-type, namely an N⁻ area; a first connection layer at a top surface of the semiconductor wafer unit is a high concentration area with the conduction type of P-type, namely a P⁺ area, and the array-distributed connection parts 2 of the first connection layer have the first ends inserted into the semiconductor wafer unit 1 and the second ends level with the top surface of the semiconductor wafer unit 1; a second connection layer at the bottom surface of the semiconductor wafer unit 1 is a high concentration area with the conduction type of N-type, namely an N⁺ area, and the array-distributed connection parts 2 of the second connection layer have the first ends inserted into the semiconductor wafer unit 1 and the second ends connected to each other on the bottom surface of the semiconductor wafer unit 1 through the conduction layer 3; the conduction layer 3 is a high concentration area with the conduction type of N-type, namely the N⁺ area; and the protection layer 4 is arranged on the conduction layer 3 at the bottom surface of the semiconductor wafer unit 1. The above three-dimensional semiconductor wafer is mainly applicable in production of Cool MOS and power integrated circuit. The three-dimensional semiconductor wafer is able to reduce a chip production difficulty, decrease a power loss by more than 10%, improve chip mechanical performance, decrease a process breakage rate by more than 10%, and provide a design and production basis for chip circuits on the top and bottom surfaces of the semiconductor wafer.

## Claims

1. A three-dimensional semiconductor wafer, comprising a semiconductor wafer unit (1), a connection layer, a conduction layer (3) and a protection layer (4), wherein the protection layer is arranged on the conduction layer; and, the connection layer and the conduction layer are arranged on the semiconductor wafer unit at a bottom surface of the semiconductor wafer unit, wherein the protection layer is connected to the conduction layer and the protection layer is a SiO2 layer, wherein the connection layer comprises a plurality of three-dimensional connection parts (2); a first end of each connection part is inserted into the semiconductor wafer unit, and a second end of each connection part is level with the bottom surface of the semiconductor wafer unit; and the connection parts are arranged inside the semiconductor wafer unit in a form of array, the semiconductor wafer unit is defined as an N⁻ area which has a conduction type of N-type; the connection layer is defined as an N⁺ area which has the conduction type of N-type; for array-distributed connection parts, first ends are inserted into the semiconductor wafer unit, and second ends are connected to each other on the bottom surface of the semiconductor wafer unit through the conduction layer; the conduction layer is defined as the N⁺ area which has the conduction type of N-type; and the protection layer is arranged on the conduction layer at the bottom surface of the semiconductor wafer unit.

2. The three-dimensional semiconductor wafer, as recited in claim 1, wherein the semiconductor wafer unit is cylindrical.

## Patentansprüche

1. Dreidimensionaler Halbleiterwafer, umfassend eine Halbleiterwafereinheit (1), eine Verbindungsschicht, eine Leitungsschicht (3) und eine Schutzschicht (4), wobei die Schutzschicht auf der Leitungsschicht angeordnet ist und die Verbindungsschicht und die Leitungsschicht an einer Bodenoberfläche der Halbleiterwafereinheit auf der Halbleiterwafereinheit angeordnet sind, wobei die Schutzschicht mit der Leitungsschicht verbunden ist und die Schutzschicht eine SiO2-Schicht ist, wobei die Verbindungsschicht eine Vielzahl von dreidimensionalen Verbindungsteilen (2) umfasst;
ein erstes Ende von jedem Verbindungsteil in die Halbleiterwafereinheit eingeführt wird und ein zweites Ende von jedem Verbindungsteil mit der Bodenoberfläche der Halbleiterwafereinheit bündig ist; und die Verbindungsteile innerhalb der Halbleiterwafereinheit in Form eines Arrays angeordnet sind, die Halbleiterwafereinheit als eine Fläche N⁻ definiert ist, die einen Leitungstyp vom N-Typ aufweist; die Verbindungsschicht als eine Fläche N⁺ definiert ist, die den Leitungstyp vom N-Typ aufweist; bei Array-verteilten Verbindungsteilen erste Enden in die Halbleiterwafereinheit eingeführt werden und zweite Enden auf der Unterseite der Halbleiterwafereinheit durch die Leitungsschicht miteinander verbunden werden; die Leitungsschicht als die Fläche N⁺ definiert ist, die den Leitungstyp vom N-Typ aufweist; und die Schutzschicht an der unteren Oberfläche der Halbleiterwafereinheit auf der Leitungsschicht angeordnet ist.

2. Dreidimensionaler Halbleiterwafer nach Anspruch 1, wobei die Halbleiterwafereinheit zylindrisch ist.

## Revendications

1. Tranche semi-conductrice tridimensionnelle, comprenant une unité de tranche semi-conductrice (1), une couche de connexion, une couche de conduction (3) et une couche de protection (4), la couche de protection étant disposée sur la couche de conduction ; et la couche de connexion et la couche de conduction étant disposées sur l'unité de tranche semi-conductrice au niveau d'une surface inférieure de l'unité de tranche semi-conductrice, la couche de protection étant connectée à la couche de conduction et la couche de protection étant une couche de SiO2, la couche de connexion comprenant une pluralité de parties de connexion tridimensionnelles (2) ; une première extrémité de chaque partie de connexion est insérée dans l'unité de tranche semi-conductrice, et une deuxième extrémité de chaque partie de connexion est au niveau de la surface inférieure de l'unité de tranche semi-conductrice ; et les parties de connexion sont disposées à l'intérieur de l'unité de tranche semi-conductrice sous forme de réseau, l'unité de tranche semi-conductrice étant définie comme une zone N⁻ qui a un type de conduction de type N ; la couche de connexion étant définie comme une zone N⁺ qui a le type de conduction de type N ; pour les parties de connexion distribuées en réseau, les premières extrémités sont insérées dans l'unité de tranche semi-conductrice, et les deuxièmes extrémités sont connectées les unes aux autres sur la surface inférieure de l'unité de tranche semi-conductrice par l'intermédiaire de la couche de conduction ; la couche de conduction est définie comme la zone N⁺ qui a le type de conduction de type N ; et la couche de protection est disposée sur la couche de conduction au niveau de la surface inférieure de l'unité de tranche semi-conductrice.

2. Tranche semi-conductrice tridimensionnelle, selon la revendication 1, dans laquelle l'unité de tranche semi-conductrice est cylindrique.
